(19) 

Europäisches
Patentamt
European
Patent Office
Office européen
des brevets

(11) **EP 4 760 307 A1**

(12) **EUROPEAN PATENT APPLICATION**
published in accordance with Art. 153(4) EPC

(43) Date of publication:
**17.06.2026 Bulletin 2026/25**

(21) Application number: **24868640.4**

(22) Date of filing: **13.09.2024**

(51) International Patent Classification (IPC):
*G01R 31/392* (2019.01)   *G01R 31/396* (2019.01)
*G01R 31/385* (2019.01)   *G01R 31/3842* (2019.01)
*H01M 10/42* (2006.01)   *H01M 10/48* (2006.01)

(52) Cooperative Patent Classification (CPC):
**G01R 31/3842; G01R 31/385; G01R 31/392;**
**G01R 31/396; H01M 10/42; H01M 10/48;**
**Y02E 60/10**

(86) International application number:
**PCT/KR2024/014049**

(87) International publication number:
**WO 2025/063663 (27.03.2025 Gazette 2025/13)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **19.09.2023 KR 20230124825**

(71) Applicant: **LG Energy Solution, Ltd.**
**Seoul 07335 (KR)**

(72) Inventor: **CHAE, Min Young**
**Daejeon 34122 (KR)**

(74) Representative: **Plasseraud IP**
**104 Rue de Richelieu**
**CS92104**
**75080 Paris Cedex 02 (FR)**

(54) **BATTERY MANAGEMENT DEVICE AND BATTERY MANAGEMENT METHOD**

(57)   A battery management apparatus disclosed herein includes a plurality of temperature sensors configured to respectively measure temperatures of a plurality of battery cells, a memory configured to cumulatively store temperature data and time data of the plurality of battery cells, received from the plurality of temperature sensors, and a controller configured to obtain battery degradation data by applying a battery degradation weight value to the temperature data and the time data and determine degradation degrees of the plurality of battery cells by comparing the battery degradation data with degradation reference data.

FIG.5

EP 4 760 307 A1

Description

[TECHNICAL FIELD]

CROSS-REFERENCE TO RELATED APPLICATION

This application claims priority to and the benefit of Korean Patent Application No. 10-2023-0124825 filed in the Korean Intellectual Property Office on September 19, 2023, the entire content of which is incorporated herein by reference.

TECHNICAL FIELD

Embodiments disclosed herein relate to a battery management apparatus and a battery management method for diagnosing a state of a battery.

[BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices. In addition, the lithium-ion battery is attracting attention as a next-generation energy storage medium as a usage range thereof is expanded to a power source of electric vehicles.
Generally, to diagnose overheating of a battery, a battery management system measures a current temperature of the battery and diagnoses battery overheating when the current temperature of the battery exceeds an over-temperature diagnosis parameter based on the over-temperature diagnosis parameter. To this end, the battery management system may use a temperature value of the battery, but may not use information about a time for which the temperature of the battery is maintained in a specific temperature range.

[DISCLOSURE]

[TECHNICAL PROBLEM]

According to an embodiment of the present disclosure, a battery management apparatus and a battery management method may be provided in which by using time information regarding a time for which a battery is maintained in a specific temperature range, a degradation rate of a battery cell may be estimated with respect to a temperature range.
Technical problems of the embodiments disclosed herein are not limited to the above-described technical problems, and other unmentioned technical problems would be clearly understood by one of ordinary skill in the art from the following description.

[TECHNICAL SOLUTION]

A battery management apparatus according to an embodiment includes a plurality of temperature sensors configured to respectively measure temperatures of a plurality of battery cells, a memory configured to cumulatively store temperature data and time data of the plurality of battery cells, received from the plurality of temperature sensors, and a controller configured to obtain battery degradation data by applying a battery degradation weight value to the temperature data and the time data and determine degradation degrees of the plurality of battery cells by comparing the battery degradation data with degradation reference data.
The controller may be further configured to determine a temperature retention time for which the temperature data is maintained in a preset temperature range, obtain battery weighted-data by multiplying the temperature retention time by the battery degradation weight value, and obtain the battery degradation data based on the battery weighted-data.
The controller may be further configured to determine a sum of battery weighted-data derived in the preset temperature range as the battery degradation data.
The controller may be further configured to determine, as the degradation reference data, an average of temperature retention times obtained by the plurality of temperature sensors.
The controller may be further configured to determine the degradation degree based on a difference between the battery degradation data and the degradation reference data.

The controller may be further configured to determine a degradation level of a battery cell corresponding to the degradation degree as a first level based on that the difference is less than or equal to a first reference value, determine the degradation level as a second level based on that the difference is less than or equal to a second reference value, and determine the degradation level as a third level based on that the difference exceeds the second reference value.

The controller may be further configured to obtain state of health (SOH) data based on the temperature data and the time data and determine a degradation degree for each temperature range for the plurality of battery cells based on the SOH data.

The controller may be further configured to determine the battery degradation weight value as a greater value in proportion to the degradation degrees of the plurality of battery cells within a same time based on a preset temperature range.

A battery management method according to an embodiment includes receiving temperature data and time data of a plurality of battery cells from a plurality of temperature sensors, accumulating the temperature data and the time data of the plurality of battery cells, received from the plurality of temperature sensors, obtaining battery degradation data by applying a battery degradation weight value to the temperature data and the time data, and determining degradation degrees of the plurality of battery cells by comparing the battery degradation data with degradation reference data.

The obtaining of the battery degradation data may include determining a temperature retention time for which the temperature data is maintained in a preset temperature range, obtaining battery weighted-data by multiplying the temperature retention time by the battery degradation weight value, and obtaining the battery degradation data based on the battery weighted-data.

The obtaining of the battery degradation data may include determining a sum of battery weighted-data derived in the preset temperature range as the battery degradation data.

The battery management method may further include determining, as the degradation reference data, an average of temperature retention times obtained by the plurality of temperature sensors.

The calculating of the degradation degree may include determining the degradation degree based on a difference between the battery degradation data and the degradation reference data.

The battery management method may further include determining a degradation level of a battery cell corresponding to the degradation degree as a first level based on that the difference is less than or equal to a first reference value, determining the degradation level as a second level based on that the difference is less than or equal to a second reference value, and determining the degradation level as a third level based on that the difference exceeds the second reference value.

The battery management method may further include obtaining state of health (SOH) data based on the temperature data and the time data and determining a degradation degree for each temperature range for the plurality of battery cells based on the SOH data.

The battery management method may further include determining the battery degradation weight value as a greater value in proportion to the degradation degrees of the plurality of battery cells within a same time based on a preset temperature range.

## [ADVANTAGEOUS EFFECTS]

With a battery management apparatus according to an embodiment, a degradation rate with respect to a temperature range in which a temperature of a battery is maintained in a battery use region may be derived, thereby quantitatively analyzing a battery cell degradation influence with respect to the temperature region in an actual battery use region such as a vehicle.

With the battery management apparatus according to an embodiment, a degradation rate with respect to a temperature range in which a temperature of a battery is maintained in a battery use region may be derived, thereby quantitatively analyzing a difference in tendency of a temperature behavior with respect to a battery pack design for each battery use region.

## [DESCRIPTION OF DRAWINGS]

FIG. 1 is a block diagram showing a configuration of a general battery system including a battery management apparatus according to an embodiment.

FIG. 2 is a block diagram showing a configuration of a battery management apparatus according to an embodiment.

FIG. 3 shows positions of a battery pack and a temperature sensor of a battery management apparatus according to an embodiment.

FIG. 4 shows a battery degradation tendency with respect to a temperature used in a battery management apparatus according to an embodiment.

FIG. 5 shows a rough flow for a battery management apparatus according to an embodiment to calculate a battery degradation degree.

FIGS. 6 and 7 show temperature range and time data used in a battery management apparatus according to an embodiment.

FIG. 8 shows a process, performed by a battery management apparatus according to an embodiment, of obtaining battery degradation data for each sensor temperature.

FIG. 9 shows battery degradation data obtained in a battery management apparatus according to an embodiment.

FIG. 10 shows degradation reference data obtained in a battery management apparatus according to an embodiment.

FIG. 11 shows a reference for a battery management apparatus according to an embodiment to derive a degradation weighting level.

FIG. 12 shows a rate of a retention time for each temperature region, obtained in a battery management apparatus according to an embodiment.

FIG. 13 shows states of health (SOH0 of a plurality of battery cells, obtained in a battery management apparatus according to an embodiment.

FIG. 14 shows a correlation between a retention time of a temperature range and a degradation rate, obtained by associating a rate of a retention time for each temperature range with SOH in a battery management apparatus according to an embodiment.

FIG. 15 is a flowchart of a battery management method according to an embodiment.

**[MODE FOR INVENTION]**

Hereinafter, various embodiments disclosed herein will be described in detail with reference to the accompanying drawings. In this document, identical reference numerals will be used for identical components in the drawings, and the identical components will not be redundantly described.

For various embodiments disclosed herein, specific structural or functional descriptions are only exemplified for the purpose of describing the embodiments, and various embodiments disclosed herein may be implemented in various forms, and should not be construed as being limited to the embodiments described herein.

As used in various embodiments, the terms "1st", "2nd", "first", "second", or the like may modify various components regardless of importance, and do not limit the components. For example, a first component may be named as a second component without departing from the right scope of an embodiment disclosed herein, and similarly, the second component may be named as the first component.

Terms used herein are used for only describing a specific exemplary embodiment and may not have an intention to limit the scope of other exemplary embodiments. It is to be understood that the singular forms include plural references unless the context clearly dictates otherwise.

All terms including technical or scientific terms used herein have the same meaning as commonly understood by those of ordinary skill in the art to which the embodiments disclosed herein belong. It will be further understood that terms, such as those defined in commonly used dictionaries, should be interpreted as having a meaning that is identical to or similar with their meaning in the context of the relevant art and will not be interpreted in an idealized or overly formal sense unless expressly so defined herein. In some cases, the terms defined herein may be interpreted to exclude embodiments disclosed herein.

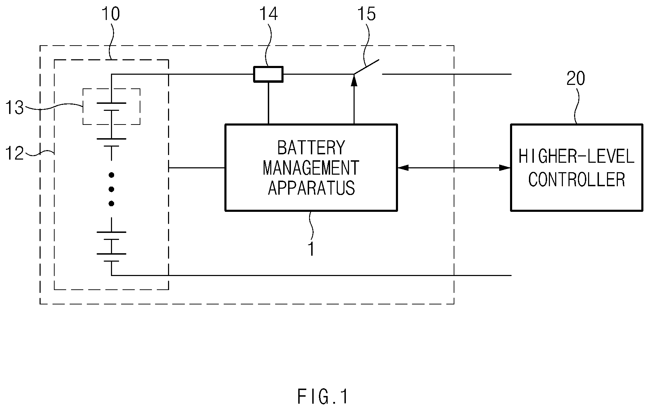

FIG. 1 is a block diagram showing a configuration of a general battery system including a battery management apparatus according to various embodiments.

Specifically, FIG. 1 schematically shows a battery system 10 and a higher-level control unit 20 included in a higher-level system according to an embodiment disclosed herein.

As shown in FIG. 1, the battery system 10 may include a plurality of battery modules 12, a sensor unit 14, a switching unit 16, and a battery management apparatus 1. The battery system 10 may include the battery module 12, the sensor unit 14, the switching unit 16, and the battery management apparatus 1 provided in plural.

The plurality of battery modules 12 may include at least one chargeable/dischargeable battery cells. The battery cell may include a positive electrode, a positive electrode material, a negative electrode, a negative electrode material, a separator, polymer, and a case. In this case, the plurality of battery modules 12 may be connected in series or in parallel.

The sensor unit 14 may include a temperature sensor 2, a current sensor (not shown), and a voltage sensor (not shown). The temperature sensor 2 may be configured to measure a battery temperature and generate a temperature signal indicating the measured battery temperature.

The temperature sensor 2 may be implemented in combination of one or two or more of known temperature detection elements such as a thermocouple, a thermistor, a bimetal, etc. The current sensor (not shown) may detect current flowing in the battery system 10. In this case, a detection signal may be transmitted to the battery management apparatus 1.

The switching unit 16 may be serially connected to a positive (+) terminal side or a negative (-) terminal side of the battery module 12 to control a charging/discharging current flow of the battery module 12. For example, for the switching unit 16, at least one relay, a magnetic contactor, etc., may be used, depending on the specification of the battery system 10.

The battery management apparatus 1 may perform control and management to prevent over-charging and over-discharging by monitoring voltage, current, temperature, etc., of the battery system 10, and may include, for example, a battery management system (BMS).

The battery management apparatus 1, which is an interface for receiving measurement values of the above-described various parameter values, may include a plurality of terminals and a circuit, etc., connected thereto to process input values. Further, the battery management apparatus 1 may control the switching unit 16, for example, on/off of a relay, a contactor, etc., and may be connected to the battery module 12 to monitor a state of each battery module 12.

The battery management apparatus 1 may receive temperature data, voltage data, and current data from the sensor unit 14 to obtain battery state information and diagnose a state of the battery.

The higher-level control unit 20 may transmit a control signal for controlling the battery module 12 to the battery management apparatus 1. Thus, the battery management apparatus 1 may be controlled in terms of an operation thereof based on the control signal applied from the higher-level control unit 20. Also, the battery module 12 may be a component included in an energy storage system (ESS). In this case, the higher-level control unit 20 may be a control unit (BBMS) of a battery bank including the plurality of battery systems 10 or an ESS control unit for controlling the entire ESS including a plurality of banks. However, the battery system 10 is not limited to such a purpose.

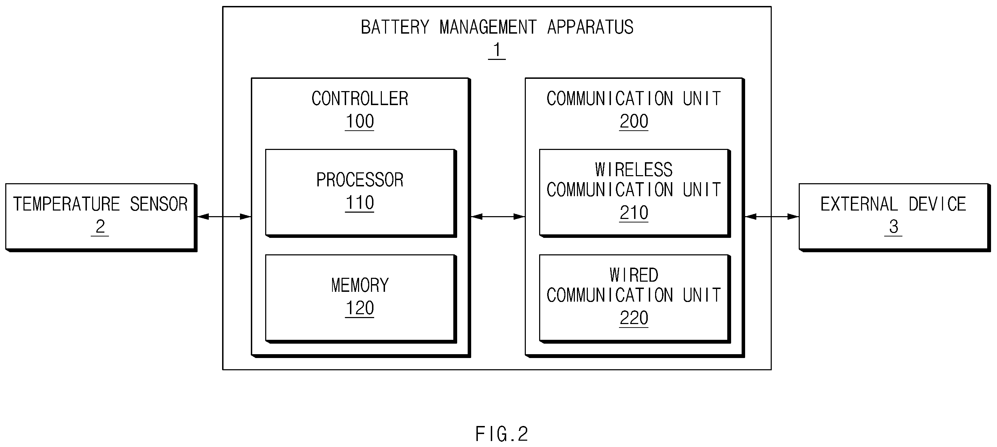

FIG. 2 is a block diagram showing a configuration of a battery management apparatus according to an embodiment.

Referring to FIG. 2, the battery management apparatus 1 according to an embodiment may include a controller 100 including at least one processor 110 and a memory 120 and a communication unit 200, and may diagnose a battery by communicating with an external device 3 through the communication unit 200.

In the present disclosure, the external device 3 communicating with the battery management apparatus 1 may include a user terminal or a server device that transmits a diagnosis result of the battery management apparatus 1. The external device 3 may include a vehicle or an ESS that transmits a cooling target temperature of a battery to the battery management apparatus 1.

Specifically, when the external device 3 is a user terminal, the controller 100 of the battery management apparatus 1 may transmit a diagnosis result of the battery to the user terminal to enable a user to check the diagnosis result. In this case, the user terminal may include, but not limited to, a personal computer (PC), a terminal, a portable telephone, a smart phone, a handheld device, a wearable device, etc.

When the external device 3 is a vehicle or an ESS, the vehicle or the ESS may transmit a temperature for maintaining the temperature of the battery within a safe range to the battery system 10. The battery system 10 may perform battery cooling control based on the temperature for maintaining the temperature of the battery within the safe range, and the battery management apparatus 1 may determine whether battery cooling control is performed normally based on the temperature for maintaining the temperature of the battery within the safe range.

When the external device 3 is a server device, the server device may be implemented with various computing devices such as workstations, clouds, data drives, data stations, etc. The server device may be implemented as one or more server devices physically or logically separated based on a function, a detailed configuration thereof, data, etc., and data may be transmitted and received through communication between server devices and the transmitted and received data may be processed.

The battery management apparatus 1 according to an embodiment may mean any electronic device including the processor 110 and the memory 120, and may be mounted on a vehicle to operate. Hereinbelow, each component of the battery management apparatus 1 may be described in detail.

The communication unit 200 may include a wireless communication unit 210 and a wired communication unit 220 to communicate with the external device 3.

The wireless communication unit 210 may include at least one of a short-range communication module or a long-range communication module.

The short-range communication module may communicate with the external device 3 adjacent to the battery management apparatus 1 by using a short-range communication method. Herein, the short-range communication module may use one communication method among Bluetooth, Bluetooth low energy (BLE), infrared data association (IrDA), Zigbee, WiFi, WiFi Direct, ultra-wideband (UWB), or near field communication (NFC).

The long-range wireless communication module may include a communication module performing various types of long-range communication, and may include a mobile communication module. The mobile communication unit may transmit and receive a radio signal to and from at least one of a base station, an external terminal, or the external device 3 over a mobile communication network. The long-range communication module may communicate with the external device 3 or other electronic devices, etc., through a nearby access point (AP). The AP may connect a local area network (LAN) to which the battery management apparatus 1 is connected to a wide area network (WAN) to which the communication server is connected. Thus, the battery management apparatus 1 may be connected to the communication server through the external device 3 and the WAN to communicate with each other.

The wired communication unit 220 may access the wired communication network and communicate with the external device 3 through the wired communication network. For example, the wired communication unit 220 may access the wired communication network through Ethernet (IEEE 802.3, technical standards), access the wired communication network through CAN communication, and transmit and receive data to and from the external devices 3 through the wired communication network.

The memory 120 may store various information required for driving of the battery management apparatus 1. Specifically, the memory 120 may store an operating system and a program required for driving of the battery management apparatus 1 or store data required for driving of the battery management apparatus 1.

For example, the memory 120 may cumulatively store temperature data and time data of the plurality of battery cells, received from a plurality of temperature sensors, and store degradation reference data determined by the controller.

The memory 120 may include a volatile memory 120 such as a static random access memory (S-RAM) and a dynamic random access memory (D-RAM) to temporarily memorize data. The memory 120 may also include a non-volatile memory 120 such as a read only memory (ROM), an erasable programmable read only memory (EPROM), and an electrically erasable programmable read only memory (EEPROM), to store data for a long time.

The processor 110 may control in overall the battery management apparatus 1 by outputting a control signal. The processor 110 may include one CPU or graphics processing unit (GPU) or a plurality of CPUs or GPUs. In this case, the processor 110 may be implemented as an array of multiple logic gates, or may be implemented as a combination of the general-purpose microprocessor 110 and the memory 120 storing a program executable on the microprocessor 110.

The controller 100 may include the processor 110 and the memory 120, and may control the above-described components to calculate degradation degrees of the plurality of battery cells.

Specifically, the controller 100 may obtain battery degradation data by applying a battery degradation weight value to the temperature data and the time data and determine the degradation degrees of the plurality of battery cells by comparing the battery degradation data with the degradation reference data. That is, the controller 100 may obtain data regarding a time for which the temperature of the battery is maintained in a specific temperature range and determine a degradation degree by applying a degradation weight value of the corresponding temperature range.

In this case, the controller 100 may determine a temperature retention time for which temperature data is maintained in a preset temperature range, multiply the temperature retention time by the battery degradation weight value to obtain battery weighted-data, and obtain the battery degradation data based on the battery weighted-data.

Thus, the controller 100 may determine, as the battery degradation data, a sum of the battery weighted-data derived from the preset temperature range. That is, the controller 100 may apply a time for which the battery data is maintained in a pre-defined temperature range to determine a sum of all of the battery weighted-data as the battery degradation data, thereby determining the degradation degree of the battery.

The controller 100 may also determine, as the degradation reference data, an average of temperature retention times obtained by the plurality of temperature sensors 2 and determine the degradation degree based on a difference between the battery degradation data and the degradation reference data. In this case, various changes such as a median value, a mode, etc., of the temperature retention times as well as the average of the temperature retention times may be made.

Specifically, the controller 100 may determine a degradation level of a battery cell corresponding to a degradation degree as a first level based on that the difference between the battery degradation data and the degradation reference data is not more than a first reference value, determine the degradation level as a second level based on that the difference is not more than a second reference value, and determine the degradation level as a third level based on that the difference exceeds the second reference value.

That is, the controller 100 may divide the degradation degree into a plurality of sections to determine a degradation level and notify a user of the degradation level, allowing the user to intuitively determine the degradation degree of the battery.

The controller 100 may also obtain state of health (SOH) data based on the temperature data and the time data and determine a degradation degree for each temperature range for the plurality of battery cells based on the SOH data.

The controller 100 may determine the battery degradation weight value as a greater value in proportion to the degradation degrees of the plurality of battery cells within the same time based on a preset temperature range.

Thus, in a process of determining the degradation degree of the battery, an influence of the temperature of the battery on the degradation degree may be considered, thereby making it possible to calculate accurate degradation degree.

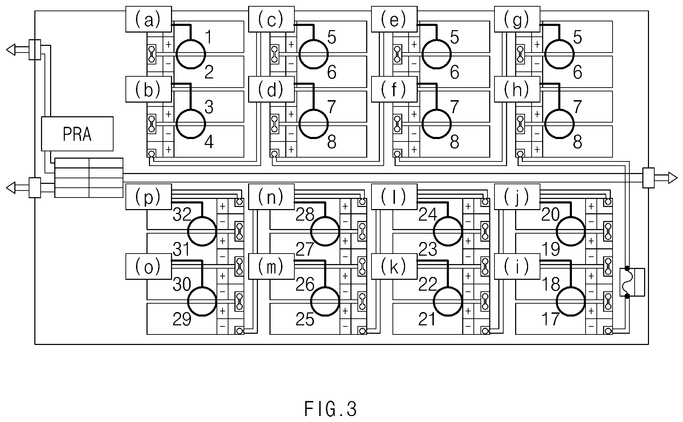

FIG. 3 shows positions of a battery pack and the temperature sensor 2 of the battery management apparatus 1 according to an embodiment.

In the battery pack, the temperature sensor 2 may be provided in plural, and may be provided in various regions (a) to (p). That is, as shown in FIG. 3, the temperature sensor 2 may be disposed in a case to measure a temperature close to an actual temperature of the battery. For example, the temperature sensor 2 may be attached to a surface of at least one battery cell included in a cell group and detect the surface temperature of the battery cell as the battery temperature.

The temperature sensor 2 may be configured to measure an external temperature that is a temperature at a predetermined position spaced apart from the battery and generate the temperature signal indicating the measured external temperature. The temperature sensor 2 may be arranged at a predetermined position outside the case in which heat exchange is made between the battery and the atmosphere.

A temperature trend of the battery pack has a similar tendency, but each of the regions (a) to (p) shows an individual temperature behavior, such that the plurality of temperature sensors 2 may sense an individual temperature behavior in each of the regions (a) to (p). Thus, the controller 100 may obtain temperature data of the plurality of battery cells and determine the degradation degree of the battery cell based on the temperature data.

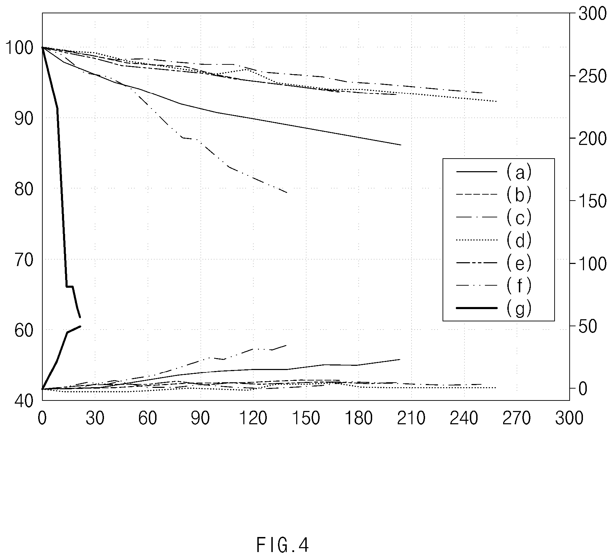

FIG. 4 shows a battery degradation tendency with respect to a temperature used in the battery management apparatus 1 according to an embodiment.

FIG. 4 shows a degradation tendency of a lithium battery for each temperature in which each graph may correspond to an individual temperature such that (a) indicates a degradation tendency for 55 °C, (b) indicates a degradation tendency for 40 °C, (c) indicates a degradation tendency for 30 °C, (d) indicates a degradation tendency for 25 °C, (e) indicates a degradation tendency for 10 °C, (f) indicates a degradation tendency for 0 °C, and (g) indicates a degradation tendency for -10 °C.

That is, as shown in FIG. 4, a capacity retention along a horizontal axis of an upper graph is measured low in low-temperature sections (f) and (g) and a high-temperature section (a), and a resistance increase value along a vertical axis of a lower graph is measured high in the low-temperature sections (f) and (g) and the high-temperature section (a).

The battery management apparatus 1 according to an embodiment may consider that the degradation of the battery is in progress differently according to a temperature range in which the temperature of the battery is maintained, thereby more accurately determining the degradation degree.

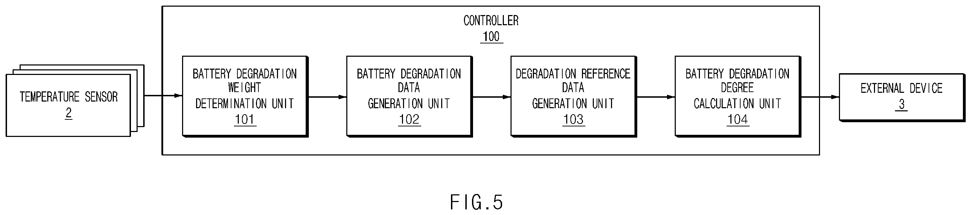

FIG. 5 shows a rough flow for the battery management apparatus 1 according to an embodiment to calculate a battery degradation degree.

Referring to FIG. 5, the controller 100 may receive, from the plurality of temperature sensors 2, a temperature value corresponding to a range in which each temperature sensor 2 is located. A battery degradation weight determination unit 101 of the controller 100 may then determine a battery degradation weight value to consider an influence of the temperature of the battery on a degradation degree of the battery in a process of determining the degradation degree of the battery.

In this case, the battery degradation weight value may be previously stored in the memory 120 or may be received by the controller 100 from the external device 3 through the communication unit 200. Specifically, the controller 100 may determine the battery degradation weight value based on data previously stored in the memory 120 by a designer of the battery management system. For example, referring to the graph of FIG. 4 together, the controller 100 may determine, as a first rank, a capacity degradation rate rank of a first range where a temperature range X is lower than or equal to -10 °C, and determine, as a second rank, a capacity degradation rate rank of a second range where the temperature range X is higher than -10 °C and is lower than or equal to 0 °C. That is, the controller 100 may set a battery degradation weight value as the greatest value, considering that the capacity degradation rate of the first range that is a low-temperature section where the temperature range X is lower than or equal to -10 °C progresses the fastest.

Taking account of a degradation rate with respect to a temperature, the controller 100 may determine, as a third rank, a capacity degradation rate rank of an eighth range where the temperature range X is higher than +55 °C, and determine, as a fourth rank, a capacity degradation rate rank of a seventh range where the temperature range X is higher than +40 °C and is lower than or equal to +55 °C.

The controller 100 may determine, as a fifth rank, a capacity degradation rate rank of a third range where the temperature range X is higher than 0 °C and is lower than or equal to +10 °C, and determine, as a sixth rank, a capacity degradation rate rank of a fourth range where the temperature range X is higher than +10 °C and is lower than or equal to +25 °C.

The controller 100 may determine, as a seventh rank, a capacity degradation rate rank of a sixth range where the temperature range X is higher than +30 °C and is lower than or equal to +40 °C, and determine, as an eighth rank, a capacity degradation rate rank of a fifth range where the temperature range X is higher than +25 °C and is lower than or equal to +30 °C. That is, the controller 100 may set a battery degradation weight value as the least value, considering that the capacity degradation rate of the sixth range that is a room-temperature section where the temperature range X is higher than +30 °C and is lower than or equal to +40 °C progresses the slowest.

Thereafter, a battery degradation data generation unit 102 of the controller 100 may determine a temperature retention time for which the temperature of the battery is maintained in a preset temperature range, and the temperature retention time by the battery degradation weight value to obtain the battery weighted-data.

The controller 100 may also determine, as the battery degradation data, a sum of the battery weighted-data derived by each temperature sensor 2.

A degradation reference data generation unit 103 of the controller 100 may then generate the degradation reference data to compare the battery degradation data with the degradation reference data. Herein, the degradation reference data may mean an average of the temperature retention times respectively obtained by the plurality of temperature sensors 2 and may also include a median value, a mode, etc., of the temperature retention times respectively obtained by the plurality of temperature sensors 2.

Thereafter, a degradation degree calculation unit 104 of the controller 100 may determine a degradation degree based on a difference between the battery degradation data and the degradation reference data. For example, the controller 100 may divide the difference between the battery degradation data and the degradation reference data into a plurality of sections and determine a degradation level corresponding to each section.

The controller 100 may transmit the determined degradation level to the external device 3, allowing the user to easily recognize a relative degradation degree of each battery cell and thus facilitating determination of a need for battery analysis.

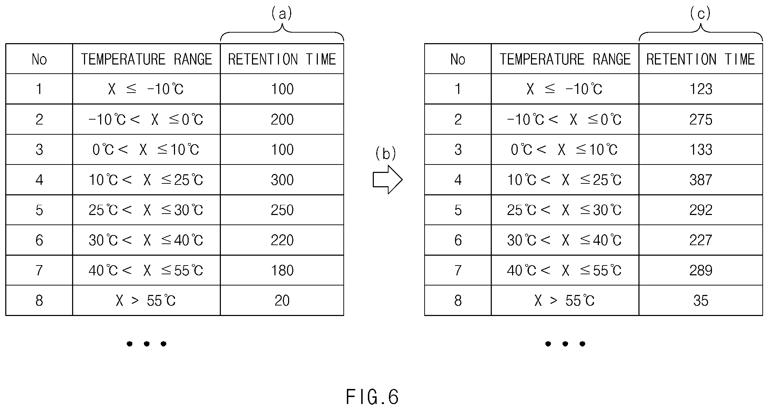

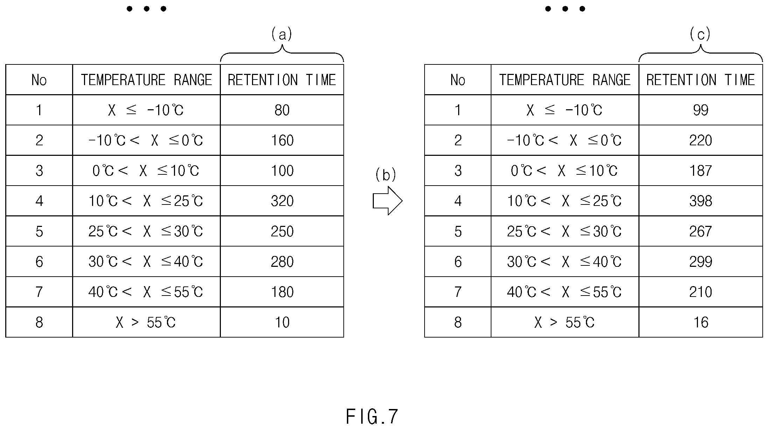

FIGS. 6 and 7 show temperature range and time data used in the battery management apparatus 1 according to an embodiment.

Referring to FIG. 6 first, assuming that the battery management apparatus 1 according to an embodiment includes n temperature sensors 2, FIG. 6 shows that temperature retention time data (a) is determined based on temperature data and time data obtained by a first temperature sensor 2.

The controller 100 may obtain the temperature retention time data (a) for a temperature range divided into 8 sections from the temperature sensor 2 and store the obtained temperature retention time data (a) in the memory 120. For example, the controller 100 may determine, as 100 minutes, the temperature retention time data (a) in a temperature range corresponding to the first section where the temperature is lower than or equal to -10 °C, and determine, as 200 minutes, the temperature retention time data (a) in a temperature range corresponding to the second section where the temperature exceeds -10 °C and is lower than or equal to 0 °C.

The controller 100 may update a cumulative time for each temperature range with respect to a time change (b), and store a cumulative retention time (c) in the memory 120 as in a right table. For example, the controller 100 may determine, as 123 minutes, the temperature retention time data (a) in the temperature range corresponding to the first section where the temperature is lower than or equal to -10 °C, and accumulate the temperature retention time data (a) in the temperature range corresponding to the second section where the temperature exceeds -10 °C and is lower than or equal to 0 °C to determine 275 minutes.

Next, referring to FIG. 7, assuming that the battery management apparatus 1 according to an embodiment includes n temperature sensors 2, FIG. 7 shows that temperature retention time data (a) is determined based on temperature data and time data obtained by an nth temperature sensor 2. In this way, the number of temperature sensors 2 included in the battery management apparatus 1 according to an embodiment is not limited.

As in FIG. 6, the controller 100 may determine, as 80 minutes, the temperature retention time data (a) in the temperature range corresponding to the first section where the temperature is lower than or equal to -10 °C, and determine, as 160 minutes, the temperature retention time data (a) in the temperature range corresponding to the second section where the temperature exceeds -10 °C and is lower than or equal to 0 °C.

Thereafter, the controller 100 may determine, as 99 minutes, the temperature retention time data (a) in the temperature range corresponding to the first section where the temperature is lower than or equal to -10 °C, and accumulate the temperature retention time data (a) in the temperature range corresponding to the second section where the temperature exceeds -10 °C and is lower than or equal to 0 °C to determine 220 minutes.

That is, the controller 100 may obtain temperature retention time data to consider temperature data changing with a position of the temperature sensor 2 as shown in FIGS. 6 and 7.

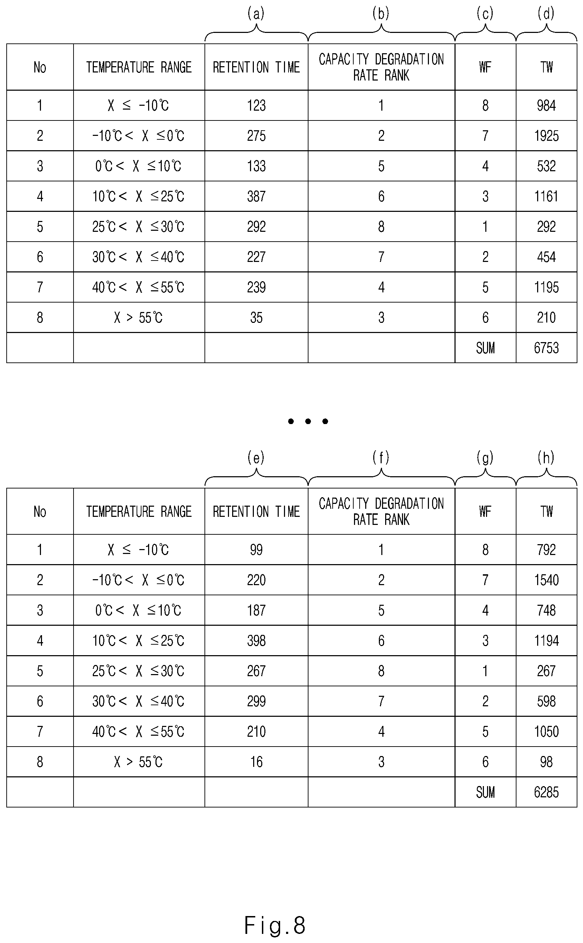

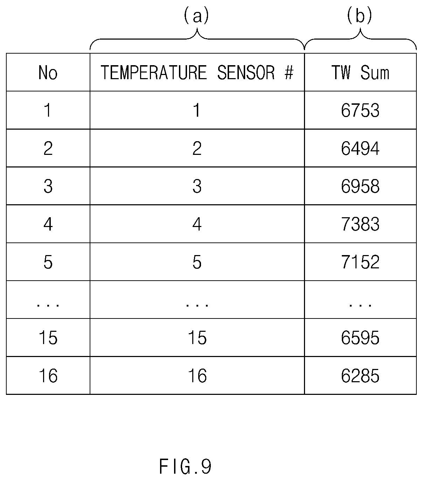

FIG. 8 shows a process, performed by the battery management apparatus 1 according to an embodiment, of obtaining battery degradation data for each sensor temperature 2, and FIG. 9 shows degradation data obtained in the battery management apparatus 1 according to an embodiment.

The controller 100 may apply the battery degradation weight value to the temperature retention time data obtained in FIGS. 6 and 7 to obtain battery weighted-data d. Herein, the battery degradation weight value may be previously stored in the memory 120 as described above or may be received by the controller 100 from the external device 3 through the communication unit 200 or may be determined by the controller 100 in inversely proportion to a degradation rate with respect to a temperature.

That is, assuming that a total of 16 temperature sensors 2 are included, an upper table of FIG. 8 shows a process, performed by the first temperature sensor 2, of obtaining the battery degradation data by summing the battery weighted-data d and a lower table of FIG. 7 shows a process, performed by a sixteenth temperature sensor 2, of obtaining the battery degradation data.

First, with the first temperature sensor 2, for example, the controller 100 may accumulate the temperature retention time data a in the temperature range corresponding to the first section where the temperature is lower than or equal to -10 °C to determine 123 minutes. The controller 100 may determine, as the first rank, a capacity degradation rate rank b of the first section corresponding to a low-temperature section where degradation of the battery progresses the fastest, and determine a corresponding battery degradation weight value WF (c) as the largest value, 8.

Thus, the controller 100 may determine a product of the retention time data (a) and the battery degradation weight value (c), 984, as the battery weighted-data (d) of the first section.

Likewise, by accumulating the temperature retention time data (a) in the temperature range corresponding to the second section where the temperature exceeds - 10 °C and is lower than or equal to 0 °C, the temperature retention time data (a) may be determined as 275 minutes. The controller 100 may determine, as the second rank, the capacity degradation rate rank b of the second section where degradation of the battery progresses second fastest, and determine the corresponding battery degradation weight value WF (c) as second largest value, 7.

Thus, the controller 100 may determine a product of the retention time data (a) and the battery degradation weight value (c), 1925, as the battery weighted-data (d) of the second section. Thereafter, the controller 100 may repeat the same algorithm up to the eighth temperature range of the first temperature sensor 2 to obtain the battery weighted-data d and may obtain the battery degradation data.

Next, with the sixteenth temperature sensor 2, for example, the controller 100 may accumulate the temperature retention time data a in the temperature range corresponding to the first section where the temperature is lower than or equal to - 10 °C to determine 99 minutes. The controller 100 may determine, as the first rank, a capacity degradation rate rank b of the first section corresponding to a low-temperature section where degradation of the battery progresses the fastest, and determine the corresponding battery degradation weight value WF (c) as the largest value, 8.

Thus, the controller 100 may determine a product of the retention time data (a) and the battery degradation weight value (c), 792, as the battery weighted-data (d) of the first section.

Likewise, by accumulating the temperature retention time data (a) in the temperature range corresponding to the second section where the temperature exceeds - 10 °C and is lower than or equal to 0 °C, the temperature retention time data (a) may be determined as 220 minutes. The controller 100 may determine, as the second rank, the capacity degradation rate rank b of the second section where degradation of the battery progresses second fastest, and determine the corresponding battery degradation weight value WF (c) as second largest value, 7.

Thus, the controller 100 may determine a product of the retention time data (a) and the battery degradation weight value (c), 1540, as the battery weighted-data (d) of the second section. Thereafter, the controller 100 may repeat the same algorithm up to the eighth temperature range of the first temperature sensor 2 to obtain the battery weighted-data d.

Next, referring to FIG. 9, the controller 100 may obtain the battery degradation data b for all temperature sensors 2 (a) included. As shown in FIG. 9, each temperature sensor 2 (a) may have different battery degradation data b according to a provided position, and as the battery degradation data b increases, the temperature sensor 2 (a) is exposed long to a temperature range where the degradation rate is high.

Thus, the controller 100 may compare the battery degradation data (b) with the degradation reference data to determine relative degradation degrees of the plurality of battery cells and also determine degradation levels.

Hereinbelow, a method, performed by the controller 100 of the battery management apparatus 1 according to an embodiment, of generating degradation reference data will be described.

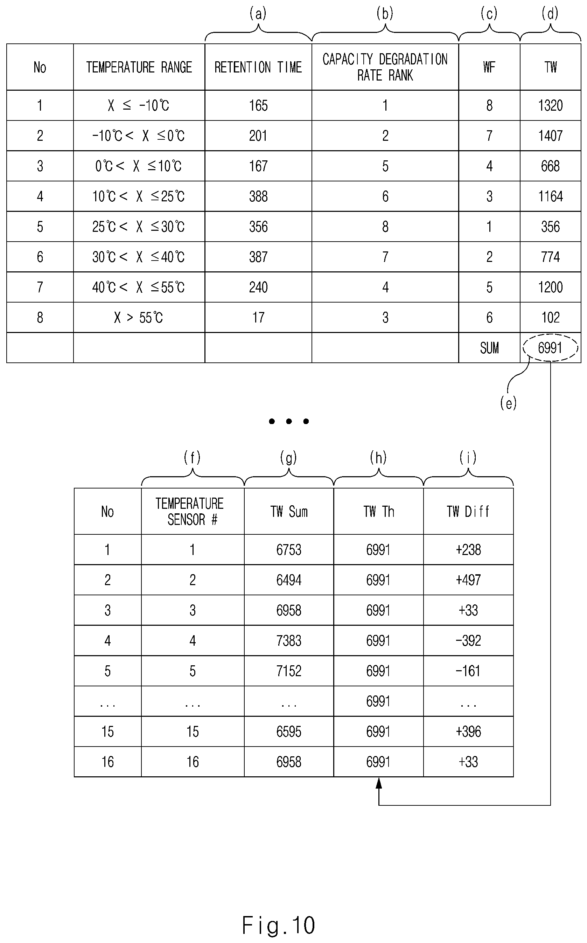

FIG. 10 shows degradation reference data obtained in the battery management apparatus 1 according to an embodiment.

Referring to an upper table of FIG. 10, the controller 100 may average the temperature data and the time data received by all the temperature sensors 2 included, thereby obtaining average temperature retention time (a). Thereafter, the controller 100 may determine the battery degradation weight value WF (c) to consider the capacity degradation rate rank (b) for the average temperature retention time data (a).

As described above, the battery degradation weight value (c) may be determined in inversely proportion to the capacity degradation rate rank (b), taking account of a speed at which the battery is degraded according to a temperature range.

For example, the controller 100 may accumulate the average temperature retention time data (a) in a temperature range corresponding to the eighth section where the temperature exceeds +55 °C to determine 165 minutes. The controller 100 may determine, as the third rank, the capacity degradation rate rank b of the eighth section corresponding to a high-temperature section where degradation of the battery progresses fast, and determine the corresponding battery degradation weight value WF (c) as 6.

Thus, the controller 100 may determine a product of the average temperature retention time data (a) and the battery degradation weight value (c), 102, as the battery weighted-data (d) of the eighth section.

The controller 100 may obtain the average battery weighted-data d with the same algorithm for the other temperature ranges, and determine a sum of the average battery weighted-data (d) for all temperature ranges as average battery degradation data (e).

Thereafter, referring to a lower table of FIG. 10, the controller 100 may obtain battery weighted-data (g) for all temperature sensors 2 (f) and determine the average battery weighted-data (e) as degradation reference data (h).

That is, like an arrow from the upper table to the lower table of FIG. 10, as the average battery weighted-data (e) is an average battery degradation rate calculated based on all the temperature sensors 2, the average battery weighted-data (e) may be determined as the degradation reference data (h). However, while the average battery weighted-data (e) is determined as the degradation reference data (h) in FIG. 10, a median value, a mode, etc., instead of an average may also be used as described above.

Thereafter, the controller 100 may determine a difference (i) between battery degradation data and degradation reference data, which corresponds to a degradation degree of the battery. The controller 100 may determine a battery degradation weighting level based on the difference i between the battery degradation data and the degradation reference data.

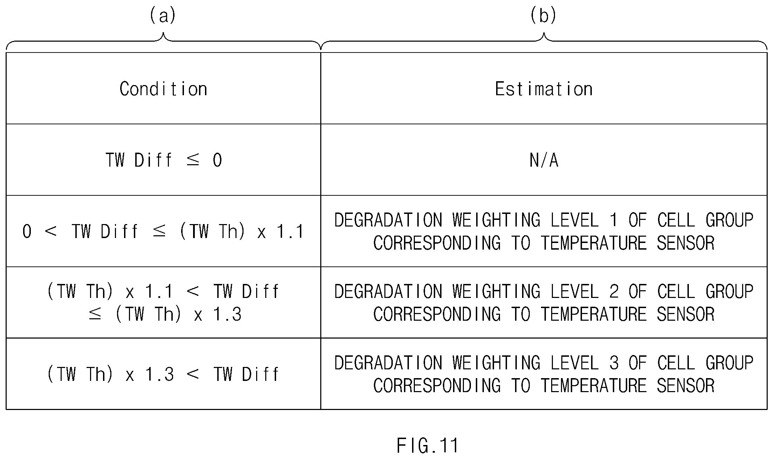

FIG. 11 shows a reference for the battery management apparatus 1 according to an embodiment to derive a degradation weighting level.

Referring to FIG. 11, the controller 100 may determine a degradation weighting level estimation value (b) based on a difference (a) between battery degradation data and degradation reference data. Specifically, the controller 100 may determine a degradation weighting level as N/A because determination of the degradation weighting level is meaningless in a first section where the difference (a) between the battery degradation data and the degradation reference data is less than or equal to 0.

Next, the controller 100 may determine a degradation weighting level of a battery cell group corresponding to the temperature sensor 2 as a first level in a second section where the difference (a) between the battery degradation data and the degradation reference data exceeds 0 and is less than or equal to 1.1 times of the degradation reference data h.

Next, the controller 100 may determine a degradation weighting level of a battery cell group corresponding to the temperature sensor 2 as a second level in a third section where the difference (a) between the battery degradation data and the degradation reference data exceeds 1.1 times of the degradation reference data h and is less than or equal to 1.3 times of the degradation reference data (h).

Next, the controller 100 may determine a degradation weighting level of a battery cell group corresponding to the temperature sensor 2 as a third level in a fourth section where the difference (a) between the battery degradation data and the degradation reference data exceeds 1.3 times of the degradation reference data h.

In this way, as the battery management apparatus 1 according to an embodiment may determine a degradation weighting level of the battery according to the difference (a) between the according to an embodiment and the degradation reference data for each temperature sensor 2 and transmit the determined degradation weighting level to the external device 3, a battery degradation degree may be easily recognized.

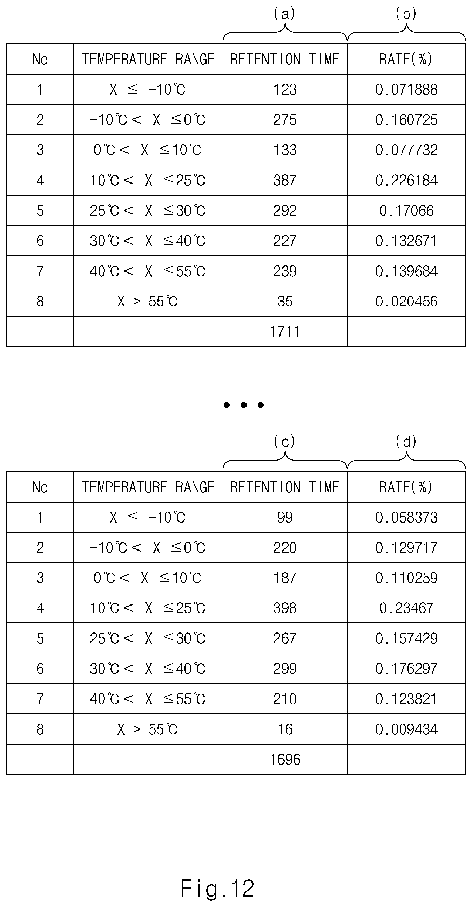

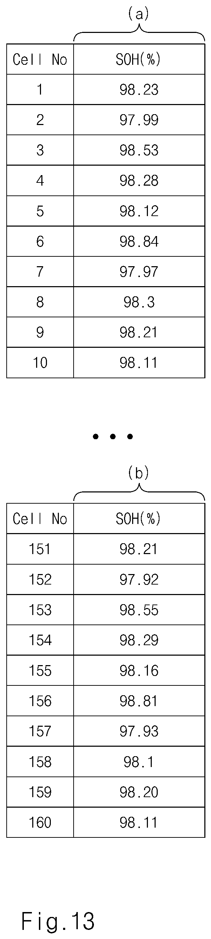

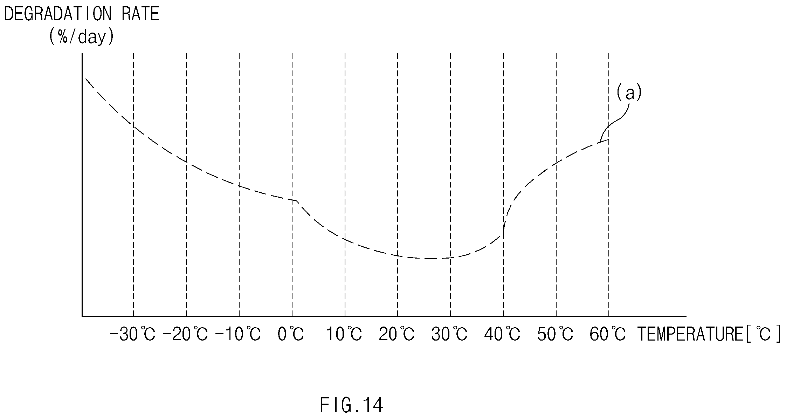

FIG. 12 shows a rate of a retention time for each temperature region, obtained in the battery management apparatus 1 according to an embodiment, FIG. 13 shows SOH of a plurality of battery cells, obtained in the battery management apparatus 1 according to an embodiment, and FIG. 14 shows a correlation between a retention time of a temperature range and a degradation rate, obtained by associating a rate of a retention time for each temperature range with SOH in the battery management apparatus 1 according to an embodiment.

Referring to FIG. 12, the controller 100 may obtain cumulative temperature retention time data (a) received from each temperature sensor 2 and determine a temperature retention time rate (b) at which the temperature of the battery is maintained in each temperature range.

For example, an upper table of FIG. 12 is related to the first temperature sensor 2 in which the cumulative temperature retention time data (a) is 123 minutes and a total cumulative temperature retention time is 1711 minutes in the first section where the temperature X of the battery is lower than or equal to - 10 °C, such that the temperature retention time rate (b) of the first section may be calculated as 0.071888 and determined as 7.1888 %.

In another example, in the upper table of FIG. 12, the cumulative temperature retention time data (a) is 275 minutes and a total cumulative temperature retention time is 1711 minutes in the second section where the temperature X of the battery exceeds - 10 °C and is lower than or equal to 0 °C, such that the temperature retention time rate (b) of the second section may be calculated as 0.160725 and determined as 16.0725 %.

Likewise, a lower table of FIG. 12 is related to the sixteenth temperature sensor 2 in which the cumulative temperature retention time data (a) is 99 minutes and a total cumulative temperature retention time is 1696 minutes in the first section where the temperature X of the battery exceeds - 10 °C and is lower than or equal to 0 °C, such that the temperature retention time rate (b) of the first section may be calculated as 0.058373 and determined as 5.8373 %.

Next, referring to FIG. 13, the controller 100 may determine SOH (a) and (b) of the plurality of battery cells based on Equation 1 regarding current integration provided below.

[Equation 1]

$$SOH[\%] = (\int Idt)/(SOC_{end} - SOC_{start}) * 100/Capacity$$

In this case, SOH may mean a concept corresponding to SOH of the battery determined based on a remaining available capacity of the battery.

The controller 100 may determine SOH (a) of each of battery cells 1 to 10 corresponding to the first temperature sensor 2 as in an upper table of FIG. 13, and determine SOH (b) of each of battery cells 151 to 160 corresponding to the sixteenth temperature sensor 2 as in a lower table of FIG..13.

Next, referring to FIG. 14, the controller 100 may analyze a correlation between SOH and a retention rate, determined according to a temperature section and temperature retention time for which the temperature of the battery is maintained, thereby quantitatively analyzing differences in temperature behavior tendency according to a battery pack design for each vehicle type through battery cell degradation influence analysis with respect to a temperature section.

That is, the controller 100 may determine SOH of a battery cell related to the plurality of temperature sensors 2, compare SOH, and determine a degradation rate, based on that the degradation rate and the SOH are proportional to each other.

FIG. 14 shows a graph (a) expressing a degradation rate, determined by the controller 100, based on SOH with respect to a temperature, in which a relationship between a degradation rate, determined by SOH, and a temperature shows a similar behavior to a relationship between a degradation rate, determined based on a battery degradation weight value, and a temperature.

Specifically, in FIG. 14, a degradation rate is maximum in a range where the temperature is lower than or equal to -30 °C, and the degradation rate gradually decreases as the temperature increases from -30 °C to 0 °C. Thereafter, the degradation rate increases from 0 °C to 40 °C, and the degradation rate is minimum in a room-temperature range and sharply increases for a temperature over 40 °C.

The controller 100 of the battery management apparatus 1 according to an embodiment may determine the degradation degree and the degradation level of the battery based on such characteristics, transmit the determined degradation degree and degradation level to the external device 3 through the communication unit 200, and inform the user of the degradation degree and the degradation level.

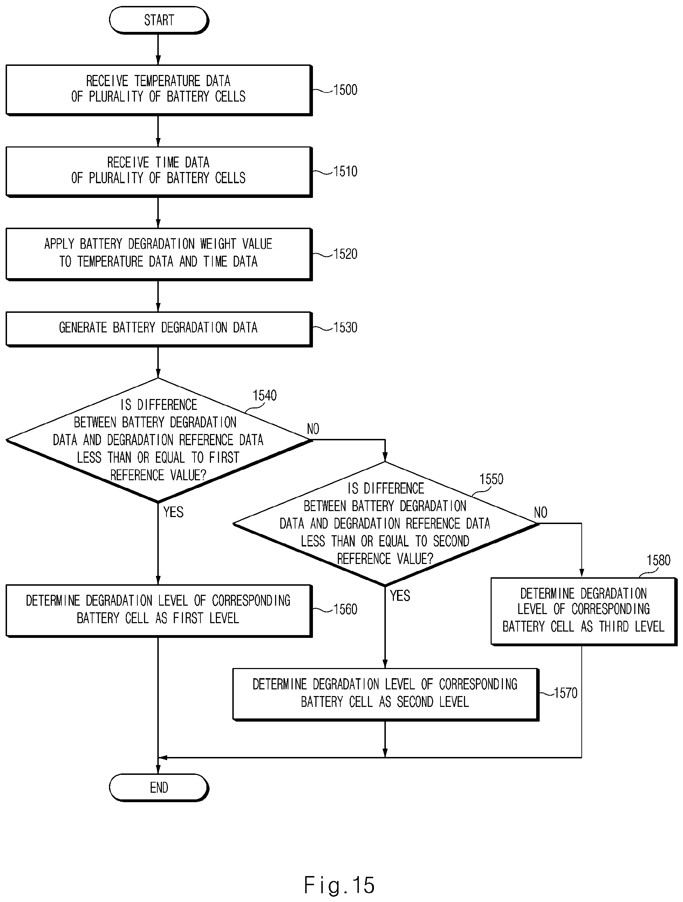

FIG. 15 is a flowchart of a battery management method according to an embodiment.

Referring to FIG. 15, the controller 100 may receive temperature data of a plurality of battery cells from the temperature sensor 2 in operation 1500 and receive time data of the plurality of battery cells in operation 1510. The controller 100 may apply a battery degradation weight value to temperature data and time data in operation 1520, and specifically, the controller 100 may use a method of multiplying a battery degradation weight value to a time for which the temperature of the battery is maintained and the method is not limited as long as the method applies the battery degradation weight value to the temperature data and the time data.

The controller 100 may apply the battery degradation weight value to the temperature data and the time data to generate battery degradation data, in operation 1530. The controller 100 may determine a difference between the battery degradation data and the degradation reference data in which the degradation reference data may mean average battery degradation data which is a sum of average battery weighted-data regarding all the temperature sensors 2.

The controller 100 may determine whether a difference between the battery degradation data and the degradation reference data is less than or equal to a first reference value in operation 1540, and determine, as a first level, a degradation level of the battery cell related to the temperature sensor 2 in operation 1560 when determining that the difference between the battery degradation data and the degradation reference data is less than or equal to the first reference value (yes in operation 1540).

The controller 100 may determine whether the difference between the battery degradation data and the degradation reference data is less than or equal to a second reference value in operation 1550 when the difference between the battery degradation data and the degradation reference data exceeds the first reference value (no in operation 1540).

In this case, when the difference between the battery degradation data and the degradation reference data is less than or equal to the second reference value (yes in operation 1550), the controller 100 may determine, as a second level, the degradation level of the battery cell related to the temperature sensor 2, in operation 1570.

When the difference between the battery degradation data and the degradation reference data exceeds the second reference value (no in operation 1550), the controller 100 may determine, as a third level, the degradation level of the battery cell related to the temperature sensor 2, in operation 1580.

As such, with the battery management apparatus 1 according to an embodiment, the degradation rate may be derived according to a temperature section in which the temperature of the battery is maintained, thereby quantitatively analyzing a degradation influence of the battery cell according to a temperature section in a battery field such as a vehicle.

Meanwhile, disclosed embodiments may be implemented in the form of a recording medium that stores an instruction executable by a computer. The instruction may be stored in the form of a program code, and, when executed by a processor, may generate a program module and perform operations according to disclosed embodiments. The recording medium may be implemented as a computer-readable recording medium.

The computer-readable recording medium may include any type of recording media that store an instruction interpretable by a computer. For example, the computer-readable recording medium may include read-only memory (ROM), random-access memory (RAM), a magnetic tape, a magnetic disk, flash memory, an optical data storage device, etc.

In addition, the computer-readable recording medium may be provided in the form of a non-transitory storage medium. Herein, the term 'non-transitory storage medium' simply means that the storage medium is a tangible device, and does not include a signal (e.g., an electromagnetic wave), but this term does not differentiate between where data is semi-permanently stored in the storage medium and where the data is temporarily stored in the storage medium. For example, the 'non-transitory storage medium' may include a buffer storing data temporarily.

According to an embodiment of the disclosure, a method according to various embodiments of the disclosure may be included and provided in a computer program product. The computer program product may be traded as a product between a seller and a buyer. The computer program product may be distributed in the form of a machine-readable recording medium (e.g., compact disc read only memory (CD-ROM)), or be distributed (e.g., downloaded or uploaded) online via an application store (e.g., PlayStore™), or between two user devices (e.g., smart phones) directly. When distributed online, at least a part of the computer program product (e.g., a downloadable app) may be temporarily generated or at least temporarily stored in the machine-readable recording medium, such as memory of the manufacturer's server, a server of the application store, or a relay server.

Even though all components constituting an embodiment disclosed herein have been described above as being combined into one or operating in combination, the embodiments disclosed herein are not necessarily limited to the embodiment. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit disclosed herein is not limited by these embodiments. The protection scope of the technical spirit disclosed herein should be interpreted by the following claims, and all technical spirits within the same range should be understood to be included in the range of this document.

## Claims

1. A battery management apparatus comprising:

   a plurality of temperature sensors configured to respectively measure temperatures of a plurality of battery cells;
   a memory configured to cumulatively store temperature data and time data of the plurality of battery cells, received from the plurality of temperature sensors; and
   a controller configured to obtain battery degradation data by applying a battery degradation weight value to the temperature data and the time data and determine degradation degrees of the plurality of battery cells by comparing the battery degradation data with degradation reference data.

2. The battery management apparatus of claim 1, wherein the controller is further configured to determine a temperature retention time for which the temperature data is maintained in a preset temperature range, obtain battery weighted-data by multiplying the temperature retention time by the battery degradation weight value, and obtain the battery degradation data based on the battery weighted-data.

3. The battery management apparatus of claim 2, wherein the controller is further configured to determine a sum of battery weighted-data derived in the preset temperature range as the battery degradation data.

4. The battery management apparatus of claim 1, wherein the controller is further configured to determine, as the degradation reference data, an average of temperature retention times obtained by the plurality of temperature sensors.

5. The battery management apparatus of claim 1, wherein the controller is further configured to determine the degradation degree based on a difference between the battery degradation data and the degradation reference data.

6. The battery management apparatus of claim 5, wherein the controller is further configured to determine a degradation level of a battery cell corresponding to the degradation degree as a first level based on that the difference is less than or equal to a first reference value, determine the degradation level as a second level based on that the difference is less than or equal to a second reference value, and determine the degradation level as a third level based on that the difference exceeds the second reference value.

7. The battery management apparatus of claim 1, wherein the controller is further configured to obtain state of health (SOH) data based on the temperature data and the time data and determine a degradation degree for each temperature range for the plurality of battery cells based on the SOH data.

8. The battery management apparatus of claim 1, wherein the controller is further configured to determine the battery degradation weight value as a greater value in proportion to the degradation degrees of the plurality of battery cells within a same time based on a preset temperature range.

9. A battery management method comprising:

receiving temperature data and time data of a plurality of battery cells from a plurality of temperature sensors;
accumulating the temperature data and the time data of the plurality of battery cells, received from the plurality of temperature sensors;
obtaining battery degradation data by applying a battery degradation weight value to the temperature data and the time data; and
determining degradation degrees of the plurality of battery cells by comparing the battery degradation data with degradation reference data.

10. The battery management method of claim 9, wherein the obtaining of the battery degradation data comprises determining a temperature retention time for which the temperature data is maintained in a preset temperature range, obtaining battery weighted-data by multiplying the temperature retention time by the battery degradation weight value, and obtaining the battery degradation data based on the battery weighted-data.

11. The battery management method of claim 10, wherein the obtaining of the battery degradation data comprises determining a sum of battery weighted-data derived in the preset temperature range as the battery degradation data.

12. The battery management method of claim 9, further comprising determining, as the degradation reference data, an average of temperature retention times obtained by the plurality of temperature sensors.

13. The battery management method of claim 9, wherein the calculating of the degradation degree comprises determining the degradation degree based on a difference between the battery degradation data and the degradation reference data.

14. The battery management method of claim 13, further comprising determining a degradation level of a battery cell corresponding to the degradation degree as a first level based on that the difference is less than or equal to a first reference value, determining the degradation level as a second level based on that the difference is less than or equal to a second reference value, and determining the degradation level as a third level based on that the difference exceeds the second reference value.

15. The battery management method of claim 9, further comprising obtaining state of health (SOH) data based on the temperature data and the time data and determining a degradation degree for each temperature range for the plurality of battery cells based on the SOH data.

16. The battery management method of claim 9, further comprising determining the battery degradation weight value as a greater value in proportion to the degradation degrees of the plurality of battery cells within a same time based on a preset temperature range.

FIG.1

BATTERY MANAGEMENT APPARATUS
1

CONTROLLER
100

PROCESSOR
110

MEMORY
120

COMMUNICATION UNIT
200

WIRELESS
COMMUNICATION UNIT
210

WIRED
COMMUNICATION UNIT
220

TEMPERATURE SENSOR
2

EXTERNAL DEVICE
3

FIG.2

FIG.3

FIG.4

FIG.5

(a)

| No | TEMPERATURE RANGE | RETENTION TIME |
|---|---|---|
| 1 | $X \leqq -10°C$ | 100 |
| 2 | $-10°C < X \leqq 0°C$ | 200 |
| 3 | $0°C < X \leqq 10°C$ | 100 |
| 4 | $10°C < X \leqq 25°C$ | 300 |
| 5 | $25°C < X \leqq 30°C$ | 250 |
| 6 | $30°C < X \leqq 40°C$ | 220 |
| 7 | $40°C < X \leqq 55°C$ | 180 |
| 8 | $X > 55°C$ | 20 |

(b) ⇧

(c)

| No | TEMPERATURE RANGE | RETENTION TIME |
|---|---|---|
| 1 | $X \leqq -10°C$ | 123 |
| 2 | $-10°C < X \leqq 0°C$ | 275 |
| 3 | $0°C < X \leqq 10°C$ | 133 |
| 4 | $10°C < X \leqq 25°C$ | 387 |
| 5 | $25°C < X \leqq 30°C$ | 292 |
| 6 | $30°C < X \leqq 40°C$ | 227 |
| 7 | $40°C < X \leqq 55°C$ | 289 |
| 8 | $X > 55°C$ | 35 |

FIG.6

• • •

(a)

| No | TEMPERATURE RANGE | RETENTION TIME |
|----|-------------------|----------------|
| 1 | X ≤ −10℃ | 80 |
| 2 | −10℃< X ≤0℃ | 160 |
| 3 | 0℃< X ≤10℃ | 100 |
| 4 | 10℃< X ≤25℃ | 320 |
| 5 | 25℃< X ≤30℃ | 250 |
| 6 | 30℃< X ≤40℃ | 280 |
| 7 | 40℃< X ≤55℃ | 180 |
| 8 | X > 55℃ | 10 |

(b) ⇨

• • •

(c)

| No | TEMPERATURE RANGE | RETENTION TIME |
|----|-------------------|----------------|
| 1 | X ≤ −10℃ | 99 |
| 2 | −10℃< X ≤0℃ | 220 |
| 3 | 0℃< X ≤10℃ | 187 |
| 4 | 10℃< X ≤25℃ | 398 |
| 5 | 25℃< X ≤30℃ | 267 |
| 6 | 30℃< X ≤40℃ | 299 |
| 7 | 40℃< X ≤55℃ | 210 |
| 8 | X > 55℃ | 16 |

FIG.7

| No | TEMPERATURE RANGE | (a) RETENTION TIME | (b) CAPACITY DEGRADATION RATE RANK | (c) WF | (d) TW |
|---|---|---|---|---|---|
| 1 | X ≦ -10℃ | 123 | 1 | 8 | 984 |
| 2 | -10℃< X ≦0℃ | 275 | 2 | 7 | 1925 |
| 3 | 0℃< X ≦10℃ | 133 | 5 | 4 | 532 |
| 4 | 10℃< X ≦25℃ | 387 | 6 | 3 | 1161 |
| 5 | 25℃< X ≦30℃ | 292 | 8 | 1 | 292 |
| 6 | 30℃< X ≦40℃ | 227 | 7 | 2 | 454 |
| 7 | 40℃< X ≦55℃ | 239 | 4 | 5 | 1195 |
| 8 | X > 55℃ | 35 | 3 | 6 | 210 |
|  |  |  |  | SUM | 6753 |

・・・

| No | TEMPERATURE RANGE | (e) RETENTION TIME | (f) CAPACITY DEGRADATION RATE RANK | (g) WF | (h) TW |
|---|---|---|---|---|---|
| 1 | X ≦ -10℃ | 99 | 1 | 8 | 792 |
| 2 | -10℃< X ≦0℃ | 220 | 2 | 7 | 1540 |
| 3 | 0℃< X ≦10℃ | 187 | 5 | 4 | 748 |
| 4 | 10℃< X ≦25℃ | 398 | 6 | 3 | 1194 |
| 5 | 25℃< X ≦30℃ | 267 | 8 | 1 | 267 |
| 6 | 30℃< X ≦40℃ | 299 | 7 | 2 | 598 |
| 7 | 40℃< X ≦55℃ | 210 | 4 | 5 | 1050 |
| 8 | X > 55℃ | 16 | 3 | 6 | 98 |
|  |  |  |  | SUM | 6285 |

Fig.8

|  | (a) | (b) |
|---|---|---|
| No | TEMPERATURE SENSOR # | TW Sum |
| 1 | 1 | 6753 |
| 2 | 2 | 6494 |
| 3 | 3 | 6958 |
| 4 | 4 | 7383 |
| 5 | 5 | 7152 |
| . . . | . . . | . . . |
| 15 | 15 | 6595 |
| 16 | 16 | 6285 |

FIG.9

| No | TEMPERATURE RANGE | RETENTION TIME (a) | CAPACITY DEGRADATION RATE RANK (b) | WF (c) | TW (d) |
|----|-------------------|--------------------|-----------------------------------|--------|--------|
| 1 | X ≤ −10℃ | 165 | 1 | 8 | 1320 |
| 2 | −10℃< X ≤0℃ | 201 | 2 | 7 | 1407 |
| 3 | 0℃< X ≤10℃ | 167 | 5 | 4 | 668 |
| 4 | 10℃< X ≤25℃ | 388 | 6 | 3 | 1164 |
| 5 | 25℃< X ≤30℃ | 356 | 8 | 1 | 356 |
| 6 | 30℃< X ≤40℃ | 387 | 7 | 2 | 774 |
| 7 | 40℃< X ≤55℃ | 240 | 4 | 5 | 1200 |
| 8 | X > 55℃ | 17 | 3 | 6 | 102 |
|  |  |  |  | SUM | 6991 |

(e)

• • •

| No | TEMPERATURE SENSOR # (f) | TW Sum (g) | TW Th (h) | TW Diff (i) |
|----|--------------------------|------------|-----------|-------------|
| 1 | 1 | 6753 | 6991 | +238 |
| 2 | 2 | 6494 | 6991 | +497 |
| 3 | 3 | 6958 | 6991 | +33 |
| 4 | 4 | 7383 | 6991 | −392 |
| 5 | 5 | 7152 | 6991 | −161 |
| ... | ... | ... | 6991 | ... |
| 15 | 15 | 6595 | 6991 | +396 |
| 16 | 16 | 6958 | 6991 | +33 |

Fig.10

| (a) | (b) |
|---|---|
| Condition | Estimation |
| TW Diff ≤ 0 | N/A |
| 0 < TW Diff ≤ (TW Th) x 1.1 | DEGRADATION WEIGHTING LEVEL 1 OF CELL GROUP CORRESPONDING TO TEMPERATURE SENSOR |
| (TW Th) x 1.1 < TW Diff ≤ (TW Th) x 1.3 | DEGRADATION WEIGHTING LEVEL 2 OF CELL GROUP CORRESPONDING TO TEMPERATURE SENSOR |
| (TW Th) x 1.3 < TW Diff | DEGRADATION WEIGHTING LEVEL 3 OF CELL GROUP CORRESPONDING TO TEMPERATURE SENSOR |

FIG.11

EP 4 760 307 A1

| No | TEMPERATURE RANGE | RETENTION TIME (a) | RATE(%) (b) |
|---|---|---|---|
| 1 | X ≤ -10℃ | 123 | 0.071888 |
| 2 | -10℃< X ≤0℃ | 275 | 0.160725 |
| 3 | 0℃< X ≤10℃ | 133 | 0.077732 |
| 4 | 10℃< X ≤25℃ | 387 | 0.226184 |
| 5 | 25℃< X ≤30℃ | 292 | 0.17066 |
| 6 | 30℃< X ≤40℃ | 227 | 0.132671 |
| 7 | 40℃< X ≤55℃ | 239 | 0.139684 |
| 8 | X > 55℃ | 35 | 0.020456 |
|  |  | 1711 |  |

• • •

| No | TEMPERATURE RANGE | RETENTION TIME (c) | RATE(%) (d) |
|---|---|---|---|
| 1 | X ≤ -10℃ | 99 | 0.058373 |
| 2 | -10℃< X ≤0℃ | 220 | 0.129717 |
| 3 | 0℃< X ≤10℃ | 187 | 0.110259 |
| 4 | 10℃< X ≤25℃ | 398 | 0.23467 |
| 5 | 25℃< X ≤30℃ | 267 | 0.157429 |
| 6 | 30℃< X ≤40℃ | 299 | 0.176297 |
| 7 | 40℃< X ≤55℃ | 210 | 0.123821 |
| 8 | X > 55℃ | 16 | 0.009434 |
|  |  | 1696 |  |

Fig.12

(a)

| Cell No | SOH(%) |
|---------|--------|
| 1 | 98.23 |
| 2 | 97.99 |
| 3 | 98.53 |
| 4 | 98.28 |
| 5 | 98.12 |
| 6 | 98.84 |
| 7 | 97.97 |
| 8 | 98.3 |
| 9 | 98.21 |
| 10 | 98.11 |

• • •

(b)

| Cell No | SOH(%) |
|---------|--------|
| 151 | 98.21 |
| 152 | 97.92 |
| 153 | 98.55 |
| 154 | 98.29 |
| 155 | 98.16 |
| 156 | 98.81 |
| 157 | 97.93 |
| 158 | 98.1 |
| 159 | 98.20 |
| 160 | 98.11 |

Fig.13

DEGRADATION RATE
(%/day)

-30℃ -20℃ -10℃ 0℃ 10℃ 20℃ 30℃ 40℃ 50℃ 60℃ TEMPERATURE[℃]

(a)

FIG.14

EP 4 760 307 A1

27

Fig.15

## INTERNATIONAL SEARCH REPORT

| International application No. |
|---|
| **PCT/KR2024/014049** |

| A. | CLASSIFICATION OF SUBJECT MATTER |
|---|---|

**G01R 31/392**(2019.01)i; **G01R 31/396**(2019.01)i; **G01R 31/385**(2019.01)i; **G01R 31/3842**(2019.01)i; **H01M 10/42**(2006.01)i; **H01M 10/48**(2006.01)i

According to International Patent Classification (IPC) or to both national classification and IPC

| B. | FIELDS SEARCHED |
|---|---|

Minimum documentation searched (classification system followed by classification symbols)

G01R 31/392(2019.01); B60L 3/00(2006.01); B60L 53/80(2019.01); B60L 58/16(2019.01); G01R 31/36(2006.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 퇴화(deterioration), 온도(temperature), 센서(sensor), 시간(time)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | KR 10-2022-0047472 A (LG ENERGY SOLUTION, LTD.) 18 April 2022 (2022-04-18)<br>See paragraphs [0039]-[0055] and figure 2. | 1-16 |
| A | KR 10-2022-0102769 A (KOREA AUTOMOTIVE TECHNOLOGY INSTITUTE) 21 July 2022 (2022-07-21)<br>See paragraphs [0028]-[0029] and figure 1. | 1-16 |
| A | KR 10-2019-0048089 A (LG CHEM, LTD.) 09 May 2019 (2019-05-09)<br>See claims 1-10. | 1-16 |
| A | JP 2016-023968 A (HITACHI AUTOMOTIVE SYSTEMS LTD.) 08 February 2016 (2016-02-08)<br>See claims 1-10. | 1-16 |
| A | JP 2015-052477 A (FUJITSU LTD.) 19 March 2015 (2015-03-19)<br>See claims 1-6. | 1-16 |

| ☐ Further documents are listed in the continuation of Box C. | ☑ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **12 December 2024** | **13 December 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/014049**

| Patent document cited in search report | | | Publication date (day/month/year) | Patent family member(s) | | | Publication date (day/month/year) |
|---|---|---|---|---|---|---|---|
| KR | 10-2022-0047472 | A | 18 April 2022 | CN | 115244413 | A | 25 October 2022 |
| | | | | EP | 4105669 | A1 | 21 December 2022 |
| | | | | JP | 2023-514203 | A | 05 April 2023 |
| | | | | JP | 7443652 | B2 | 06 March 2024 |
| | | | | US | 2023-0120067 | A1 | 20 April 2023 |
| | | | | WO | 2022-075628 | A1 | 14 April 2022 |
| KR | 10-2022-0102769 | A | 21 July 2022 | | None | | |
| KR | 10-2019-0048089 | A | 09 May 2019 | CN | 110573370 | A | 13 December 2019 |
| | | | | CN | 110573370 | B | 10 January 2023 |
| | | | | EP | 3604018 | A1 | 05 February 2020 |
| | | | | EP | 3604018 | B1 | 12 January 2022 |
| | | | | US | 11175347 | B2 | 16 November 2021 |
| | | | | US | 2020-0081068 | A1 | 12 March 2020 |
| | | | | WO | 2019-088504 | A1 | 09 May 2019 |
| JP | 2016-023968 | A | 08 February 2016 | CN | 106662621 | A | 10 May 2017 |
| | | | | CN | 106662621 | B | 15 September 2020 |
| | | | | EP | 3171187 | A1 | 24 May 2017 |
| | | | | EP | 3171187 | B1 | 28 August 2019 |
| | | | | JP | 6324248 | B2 | 16 May 2018 |
| | | | | US | 10725111 | B2 | 28 July 2020 |
| | | | | US | 2017-0131360 | A1 | 11 May 2017 |
| | | | | WO | 2016-009757 | A1 | 21 January 2016 |
| JP | 2015-052477 | A | 19 March 2015 | JP | 6326745 | B2 | 23 May 2018 |
| | | | | US | 2015-0067379 | A1 | 05 March 2015 |
| | | | | US | 9915705 | B2 | 13 March 2018 |

Form PCT/ISA/210 (patent family annex) (July 2022)

**EP 4 760 307 A1**

**Patent documents cited in the description**

- KR 1020230124825